(19) Europäisches Patentamt
European Patent Office
Office européen des brevets

(11) **EP 4 564 038 B1**

(12) **EUROPEAN PATENT SPECIFICATION**

(45) Date of publication and mention
of the grant of the patent:
**20.05.2026 Bulletin 2026/21**

(21) Application number: **24212344.6**

(22) Date of filing: **12.11.2024**

(51) International Patent Classification (IPC):
**G01R 31/42** *(2006.01)* **G01R 31/52** *(2020.01)*
**G01R 27/18** *(2006.01)*

(52) Cooperative Patent Classification (CPC):
**G01R 31/52; G01R 27/18; G01R 31/42**

(54) **POWER SYSTEM AND METHOD FOR DETECTING GROUND IMPEDANCE**

STROMVERSORGUNGSSYSTEM UND VERFAHREN ZUR ERKENNUNG VON ERDIMPEDANZ

SYSTÈME D'ALIMENTATION ET PROCÉDÉ DE DÉTECTION D'IMPÉDANCE DE MASSE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **30.11.2023 CN 202311635167**

(43) Date of publication of application:
**04.06.2025 Bulletin 2025/23**

(73) Proprietor: **Huawei Digital Power Technologies
Co., Ltd.
Shenzhen, Guangdong 518043 (CN)**

(72) Inventors:
• **LI, Lin
Shenzhen, 518043 (CN)**
• **JU, Hualei
Shenzhen, 518043 (CN)**
• **YANG, Boping
Shenzhen, 518043 (CN)**

(74) Representative: **Gill Jennings & Every LLP
The Broadgate Tower
20 Primrose Street
London EC2A 2ES (GB)**

(56) References cited:
CN-A- 115 356 540      US-A1- 2012 249 038
US-A1- 2013 272 039      US-A1- 2013 322 133

**Description**

**TECHNICAL FIELD**

This application relates to the field of power electronics, and in particular, to a power system and a method for detecting a ground impedance.

**BACKGROUND**

To improve reliability of a photovoltaic system or a photovoltaic energy storage system, a ground impedance short-circuit fault of the system needs to be monitored. A ground impedance of the system may be abnormal due to reasons such as liquid leakage, non-standard construction, and friction between a cable and a support in the system, causing a short circuit to ground of a cable of a photovoltaic string or the like in the system. When the ground impedance is abnormal, a ground impedance abnormality or an alarm needs to be reported. In a conventional power generation and power supply system, a dedicated detection device is usually installed to specially detect the ground impedance of the system. However, the dedicated detection device is expensive and system complexity is increased, resulting in high procurement, installation, and maintenance costs. Considering compatibility and costs, a ground impedance detection function may be gradually integrated into another device in the system, for example, integrated into an anti-potential induced degradation device. The anti-potential induced degradation device is reused to implement the ground impedance detection function.

In a research and experiment process, inventors of this application find that, when the anti-potential induced degradation device is reused to implement ground impedance detection, because an external resistor needs to be used outside the anti-potential induced degradation device for coordination, detection costs are high. In addition, only a ground impedance of an alternating current side of the system can be detected, and a ground impedance of a direct current side cannot be detected, resulting in poor impedance short-circuit fault detection effect.

US 2013/322133 A1 discloses detection of high resistance ground faults in a power distribution system.

**SUMMARY**

Embodiments of this application provide a power system and a method for detecting a ground impedance. Ground impedances of both an alternating current side and a direct current side of the power system can be detected, so that an impedance short-circuit fault detection range is wider.

According to a first aspect, this application provides a power system. The power system includes a converter and a short-circuit detection apparatus. An input end of the converter is configured to connect to a direct current power supply. An output end of the converter is configured to be coupled to an alternating current load. The converter includes a positive bus capacitor and a negative bus capacitor that are connected in series. A series connection point between the positive bus capacitor and the negative bus capacitor is a neutral point. The short-circuit detection apparatus is connected to an equivalent neutral point. A ground potential difference of the equivalent neutral point is positively correlated with a ground potential difference of the neutral point. The equivalent neutral point includes a connection end of three phases of output ends of the converter. The short-circuit detection apparatus is configured to: output a first voltage value to the equivalent neutral point, obtain a first current value of the short-circuit detection apparatus in a case in which the first voltage value is output, output a second voltage value to the equivalent neutral point, and obtain a second current value of the short-circuit detection apparatus in a case in which the second voltage value is output. The short-circuit detection apparatus is configured to: in response to a ratio of a difference between the first voltage value and the second voltage value to a difference between the first current value and the second current value being less than a specified threshold, report or send ground impedance abnormality fault information.

In this application, the short-circuit detection apparatus may perform voltage regulation on the equivalent neutral point a plurality of times, and obtain ground impedances of an alternating current side and a direct current side of a discharging system based on a voltage value and a current value obtained after each voltage regulation. The short-circuit detection apparatus obtains a ground impedance of the power system without an additional resistance, thereby reducing detection costs. In addition, ground impedances of both an alternating current side and a direct current side of the power system can be detected. In response to the ground impedance being less than the specified threshold, the short-circuit detection apparatus may determine that a ground impedance of a line between the direct current power supply (which may be a photovoltaic module or an energy storage battery) and the input end of the converter is abnormal, or a ground impedance of a line between the output end of the converter and a primary-side winding of a transformer is abnormal, so that a ground impedance detection range is wider.

In a possible implementation, the ground impedance of the power system is positively correlated with the ratio of the difference between the first voltage value and the second voltage value to the difference between the first current value and the second current value. The short-circuit detection apparatus is configured to: in response to the ground impedance being less than the specified threshold, determine that the ground impedance of the line between the direct current power supply and the input end of the converter is abnormal, or a ground impedance of a line between the output end of the converter and the alternating current load is abnormal. The short-circuit detection apparatus obtains the ground impedance of the power system without an additional resistance, thereby reducing detection costs. In addition, the ground impedances of both the alternating current side and the direct current side of the power system can be detected, so that an impedance short-circuit fault detection range is wider, thereby improving working reliability of the power system.

In a possible implementation, the power system includes a transformer. An output end of the converter is connected to the primary-side winding of the transformer. A secondary-side winding of the transformer is configured to connect to the alternating current load. The short-circuit detection apparatus is connected to an equivalent neutral point on the transformer. The short-circuit detection apparatus may perform voltage regulation on the equivalent neutral point a plurality of times, and obtain ground impedances of an alternating current side and a direct current side of a discharging system based on a voltage value and a current value obtained after each voltage regulation.

In a possible implementation, the short-circuit detection apparatus is configured to: output the first voltage value to the equivalent neutral point at a first moment, and output the second voltage value to the equivalent neutral point at a second moment, where a time interval between the first moment and the second moment is an integer multiple of a cycle of an output alternating current voltage of the converter; and obtain the ground impedance based on the ratio of the difference between the first voltage value and the second voltage value to the difference between the first current value and the second current value. Herein, a time interval between a moment at which the short-circuit detection apparatus outputs the first voltage value and a moment at which the short-circuit detection apparatus outputs the second voltage value is an integer multiple of a cycle of an output alternating current voltage of the converter. Therefore, interference from an output voltage of the converter or interference from an output voltage and current of a grid can be offset, thereby further improving accuracy of obtaining the ground impedance of the power system by the short-circuit detection apparatus.

In a possible implementation, the short-circuit detection apparatus is configured to: output an alternating current voltage to the equivalent neutral point, where high-level duration of the alternating current voltage is a first time interval, and low-level duration of the alternating current voltage is a second time interval; obtain the first voltage value output by the short-circuit detection apparatus in a period in which the alternating current voltage is at a high level and a first current average value of the short-circuit detection apparatus in a case in which the first voltage value is output; and obtain the second voltage value output by the short-circuit detection apparatus in a period in which the alternating current voltage is at a low level and a second current average value of the short-circuit detection apparatus in a case in which the second voltage value is output, where the first time interval and the second time interval are integer multiples of a cycle of an output alternating current voltage of the converter; and obtain the ground impedance based on a ratio of the difference between the first voltage value and the second voltage value to a difference between the first current average value and the second current average value. Herein, both the high-level duration and the low-level duration of the alternating current voltage output by the short-circuit detection apparatus are integer multiples of a cycle of an output alternating current voltage of the converter. Therefore, interference from an output voltage of the converter or interference from an output voltage and current of a grid can be offset, thereby further improving accuracy of obtaining the ground impedance of the power system by the short-circuit detection apparatus.

In a possible implementation, an alternating current voltage waveform output by the short-circuit detection apparatus is a square wave or a trapezoidal wave. Both the high-level duration and the low-level duration of the alternating current voltage are integer multiples of a cycle of an output alternating current voltage of the converter. Therefore, interference from an output voltage of the converter or interference from an output voltage and current of a grid can be offset, thereby further improving accuracy of obtaining the ground impedance of the power system by the short-circuit detection apparatus.

In a possible implementation, the alternating current voltage waveform output by the short-circuit detection apparatus is superposition of the square wave and a periodically fluctuating signal, or superposition of the trapezoidal wave and the periodically fluctuating signal. An integer multiple of a cycle of the periodically fluctuating signal period is equal to the first time interval and the second time interval. Duration of the first time interval and duration of the second time interval are equal to an integer multiple of a cycle of a superposed sinusoidal wave. In this case, the short-circuit detection apparatus obtains a superposed average value of the voltage output by the short-circuit detection apparatus and an alternating current voltage output by a port of any phase of the converter in the first time interval or the second time interval. The superposed sinusoidal wave and the alternating current voltage output by the port of any phase can be offset, and subsequent calculation of the ground impedance is not affected.

In a possible implementation, the converter includes an inverter circuit, and the inverter circuit includes at least one bridge arm and the positive bus capacitor and the negative bus capacitor that are connected in series. The bridge arm is connected in parallel to two ends of the positive bus capacitor and the negative bus capacitor that are connected in series. One end of the bridge arm is connected to a connection end of the positive bus capacitor and the negative bus capacitor, and the other end of the bridge arm is configured to be coupled to the alternating current load.

In a possible implementation, the converter includes a direct current conversion circuit. An input end of the direct current conversion circuit is configured to connect to the direct current power supply, and a positive electrode output end and a negative electrode output end of the direct current conversion circuit are respectively connected to the two ends of the positive bus capacitor and the negative bus capacitor that are connected in series.

According to a second aspect, this application provides a method for detecting a ground impedance. The method includes: outputting a first voltage value to an equivalent neutral point, obtaining a first current value that is output in a case in which the first voltage value is output, outputting a second voltage value to the equivalent neutral point, and obtaining a second current value that is output in a case in which the second voltage value is output; and in response to a ratio of a difference between the first voltage value and the second voltage value to a difference between the first current value and the second current value being less than a specified threshold, reporting or sending ground impedance abnormality fault information. A ground potential difference of the equivalent neutral point is positively correlated with a ground potential difference of a neutral point. The neutral point is a series connection point between a positive bus capacitor and a negative bus capacitor in a converter. An input end of the converter is configured to connect to a direct current power supply, and an output end of the converter is configured to be coupled to an alternating current load.

In this application, voltage regulation is performed on the equivalent neutral point a plurality of times, and ground impedances of an alternating current side and a direct current side of a discharging system are obtained with reference to a voltage value and a current value obtained after each voltage regulation. A ground impedance of a power system is obtained without an additional resistance, thereby reducing detection costs. In addition, ground impedances of both an alternating current side and a direct current side of the power system can be detected. In response to the ground impedance being less than the specified threshold, it may be determined that a ground impedance of a line between the direct current power supply (which may be a photovoltaic module or an energy storage battery) and the input end of the converter is abnormal, or a ground impedance of a line between the output end of the converter and a primary-side winding of a transformer is abnormal, so that a ground impedance detection range is wider.

In a possible implementation, the ground impedance of the power system is positively correlated with the ratio of the difference between the first voltage value and the second voltage value to the difference between the first current value and the second current value. The method includes: in response to the ground impedance being less than the specified threshold, determining that the ground impedance of the line between the direct current power supply and the input end of the converter is abnormal, or a ground impedance of a line between the output end of the converter and the alternating current load is abnormal. The ground impedance of the power system is obtained without an additional resistance, thereby reducing detection costs. In addition, ground impedances of both an alternating current side and a direct current side of the power system can be detected, so that an impedance short-circuit fault detection range is wider.

In a possible implementation, the method includes: outputting the first voltage value to the equivalent neutral point at a first moment, and outputting the second voltage value to the equivalent neutral point at a second moment. A time interval between the first moment and the second moment is an integer multiple of a cycle of an output alternating current voltage of the converter. Herein, a time interval between a moment at which the first voltage value is output and a moment at which the second voltage value is output is an integer multiple of a cycle of an output alternating current voltage of the converter. Therefore, interference from an output voltage of the converter or interference from an output voltage and current of a grid can be offset, thereby further improving accuracy of obtaining the ground impedance of the power system.

In a possible implementation, the method includes: outputting an alternating current voltage to the equivalent neutral point, where high-level duration of the alternating current voltage is a first time interval, and low-level duration of the alternating current voltage is a second time interval; obtaining the first voltage value output to the equivalent neutral point in a period in which the alternating current voltage is at a high level and a first current average value output in a case in which the first voltage value is output; and obtaining the second voltage value output to the equivalent neutral point in a period in which the alternating current voltage is at a low level and a second current average value output in a case in which the second voltage value is output, where the first time interval and the second time interval are integer multiples of a cycle of an output alternating current voltage of the converter; and obtaining the ground impedance based on a ratio of the difference between the first voltage value and the second voltage value to a difference between the first current average value and the second current average value. Both the high-level duration and the low-level duration of the output alternating current voltage are integer multiples of a cycle of an output alternating current voltage of the converter. Therefore, interference from an output voltage of the converter or interference from an output voltage and current of a grid can be offset, thereby further improving accuracy of obtaining the ground impedance of the power system by a short-circuit detection apparatus.

In a possible implementation, an alternating current voltage waveform output to the equivalent neutral point is a square wave or a trapezoidal wave. Alternatively, the alternating current voltage waveform output to the equivalent neutral point is superposition of the square wave and a periodically fluctuating signal, or superposition of the trapezoidal wave and the periodically fluctuating signal. An integer multiple of a cycle of the periodically fluctuating signal is equal to the first time interval and the second time interval. Duration of the first time interval and duration of the second time interval are equal to an integer multiple of a cycle of a superposed sinusoidal wave. In this case, a superposed average value of the output voltage and an alternating current voltage output by a port of any phase of the converter in the first time interval or the second time interval is obtained. The superposed sinusoidal wave and the alternating current voltage output by the port of any phase can be offset, and subsequent calculation of the ground impedance is not affected.

## BRIEF DESCRIPTION OF DRAWINGS

FIG. 1 is a diagram of an application scenario of a power system according to this application;
FIG. 2 is a diagram of a structure of a power system according to this application;
FIG. 3 is a diagram of another structure of a power system according to this application;
FIG. 4 is a diagram of another structure of a power system according to this application;
FIG. 5 is a diagram of another structure of a power system according to this application;
FIG. 6 is a schematic of an equivalent circuit on an alternating current side of a power system according to this application;
FIG. 7 is a schematic of an equivalent circuit on a direct current side of a power system according to this application;
FIG. 8 is a diagram of an output voltage waveform of a short-circuit detection apparatus according to this application;
FIG. 9 is a schematic of equivalent circuits on an alternating current side and a direct current side of a power system according to this application;
FIG. 10 is a diagram of another output voltage waveform of a short-circuit detection apparatus according to this application; and
FIG. 11 is a diagram of another output voltage waveform of a short-circuit detection apparatus according to this application.

## DESCRIPTION OF EMBODIMENTS

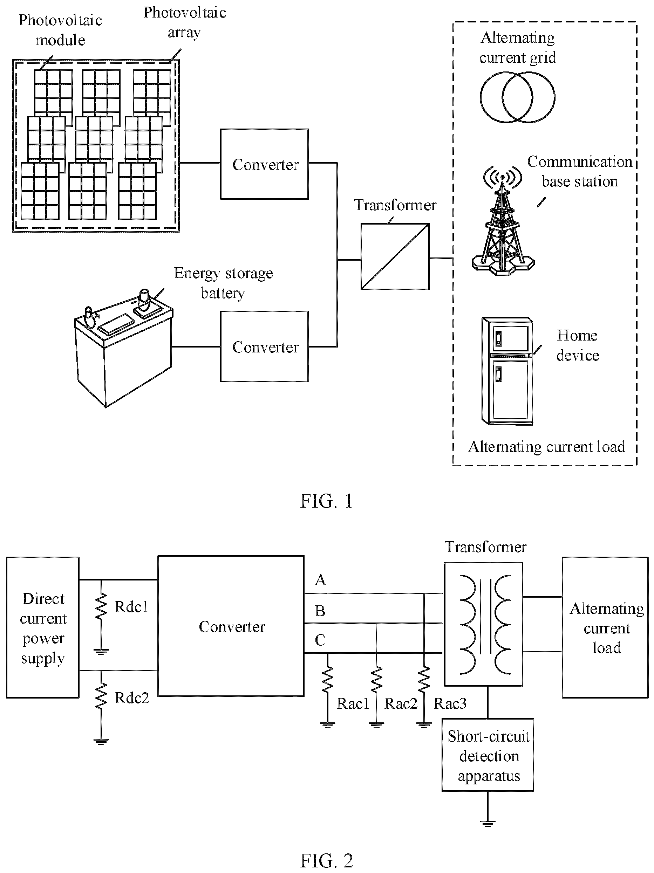

FIG. 1 is a diagram of an application scenario of a power system according to this application. The power system provided in this application may include a direct current power supply and a converter. The direct current power supply may include a photovoltaic array. An output end of the photovoltaic array may be connected to a first end of the converter, and a second end of the converter is connected to an alternating current load. In the power system shown in FIG. 1, the photovoltaic array may include one or more photovoltaic strings connected in parallel, and one photovoltaic string may be obtained by connecting one or more photovoltaic modules in series. The converter may perform voltage conversion on a direct current provided by the photovoltaic array, and then output an alternating current to the alternating current load. The alternating current load may be an alternating current grid or an alternating current power consuming device. Herein, when the converter is on-grid, the alternating current load may be the alternating current grid, and when the converter is off-grid, the alternating current load may be the alternating current electric device.

In some feasible implementations, still with reference to FIG. 1, the direct current power supply may further include an energy storage battery. An output end of the energy storage battery may be connected to the first end of the converter, and the second end of the converter is connected to the alternating current load. The converter may convert a direct current provided by the energy storage battery, and output an alternating current obtained through conversion to the alternating current load for power supply.

In some feasible implementations, still with reference to FIG. 1, the power system may include a transformer. The second end of the converter may be connected to the alternating current load through the transformer. The transformer may change (for example, boost or buck) an alternating current provided by the converter, and output a converted alternating current power to the alternating current load for power supply.

In the application scenario shown in FIG. 1, a ground impedance of the system may be abnormal due to reasons such as liquid leakage, non-standard construction, and friction between a cable and a support in the power system. For example, a short circuit to ground of a cable of a photovoltaic string or the like in the system may be caused. When the ground impedance is abnormal, a ground impedance abnormality or an alarm needs to be reported, so that the faulty cable can be repaired or replaced in a timely manner. In a conventional power generation and power supply system, a dedicated detection device is usually installed to specially detect the ground impedance of the system. However, the dedicated detection device is expensive and system complexity is increased, resulting in high procurement, installation, and maintenance costs. Considering compatibility and costs, a ground impedance detection function may be gradually integrated into another device in the system, for example, integrated into an anti-potential induced degradation (Potential Induced Degradation, PID) device. The anti-PID device is reused to implement the ground impedance detection function. After being used for a period of time, the photovoltaic module may experience deterioration in power generation performance, leading to a decrease in an output power of an entire photovoltaic system. The anti-PID device is used to raise a voltage of the photovoltaic module, so that an excessively low common-mode voltage to ground of the photovoltaic module can be avoided, and power generation performance of the photovoltaic module is maintained. However, when the anti-PID device is reused to implement ground impedance detection, because an external resistor needs to be used outside the anti-PID device for collaboration, detection costs are high. In addition, only a ground impedance of an alternating current side of the power system can be detected, and a ground impedance of a direct current side cannot be detected, resulting in poor impedance short-circuit fault detection effect.

In the power system provided in this application, the power system may include the converter and a short-circuit detection apparatus (not shown in FIG. 1). When the direct current power supply connected to the converter of the power system includes a photovoltaic string, the short-circuit detection apparatus included in the power system may be the anti-PID device. When the direct current power supply connected to the converter includes only the energy storage battery, the short-circuit detection apparatus may be another device having a voltage source function. This may be specifically determined based on an actual application scenario requirement, and is not limited herein. The converter may include a positive bus capacitor and a negative bus capacitor that are connected in series. A series connection point between the positive bus capacitor and the negative bus capacitor is a neutral point. The short-circuit detection apparatus may be connected to an equivalent neutral point. A ground potential difference of the equivalent neutral point is positively correlated with a ground potential difference of the neutral point. Specifically, the short-circuit detection apparatus may perform voltage regulation on the equivalent neutral point at least twice. In other words, the short-circuit detection apparatus may output a voltage value to the equivalent neutral point at least twice. The short-circuit detection apparatus obtains a first voltage value and a second voltage value in a plurality of voltage regulations, and obtains a first current value of the short-circuit detection apparatus in a case in which the first voltage value is output and a second current value of the short-circuit detection apparatus in a case in which the second voltage value is output. Further, the short-circuit detection apparatus may determine ground impedances of the power system based on a difference between the first voltage value and the second voltage value and a difference between the first current value and the second current value. Herein, the short-circuit detection apparatus may perform voltage regulation on the equivalent neutral point a plurality of times, and obtain ground impedances of an alternating current side and a direct current side of a discharging system based on a voltage value and a current value obtained after each voltage regulation. The short-circuit detection apparatus obtains the ground impedance of the power system without an additional resistance, thereby reducing detection costs. In addition, ground impedances of both the alternating current side and the direct current side of the power system can be detected. In response to the ground impedance being less than a specified threshold, the short-circuit detection apparatus may determine that a ground impedance of a line between the direct current power supply (which may be the photovoltaic module or the energy storage battery) and an input end of the converter is abnormal (for example, has a short circuit to ground), or a ground impedance of a line between an output end of the converter and a primary-side winding of the transformer is abnormal, so that a ground impedance detection range is wider.

FIG. 2 is a diagram of a structure of a power system according to this application. The power system shown in FIG. 2 may include a direct current power supply, a converter, and a transformer. The direct current power supply may be a photovoltaic array including a plurality of photovoltaic strings, an energy storage battery, or the like. An input end of the converter is connected to the direct current power supply in the power system, and an output end of the converter is coupled to an alternating current grid through the transformer. In the power system shown in FIG. 2, the converter performs conversion on a direct current output by the direct current power supply, and outputs an alternating current (which may be a first alternating current) obtained through conversion to the transformer. The transformer performs voltage conversion based on the alternating current output by the converter, and outputs a boosted or bucked alternating current (which may be a second alternating current) to the alternating current grid through a grid-connected point, to supply power to an alternating current load.

In the power system shown in FIG. 2, the power system may include a short-circuit detection apparatus. The short-circuit detection apparatus may be a device having a voltage source function, for example, may be an anti-PID device. This may be specifically determined based on an actual application scenario requirement, and is not limited herein. The converter may include a positive bus capacitor and a negative bus capacitor (not shown in FIG. 2) that are connected in series. A series connection point between the positive bus capacitor and the negative bus capacitor is a neutral point. The short-circuit detection apparatus may be connected to an equivalent neutral point. A ground potential difference of the equivalent neutral point is positively correlated with a ground potential difference of the neutral point. For example, the short-circuit detection apparatus may be connected to an equivalent neutral point on the transformer. Specifically, the equivalent neutral point on the transformer may be a common contact point in which head ends of coils included in the transformer are connected together in a case of a star connection between the transformer and the converter. The short-circuit detection apparatus may perform voltage regulation on the equivalent neutral point on the transformer at least twice. In other words, the short-circuit detection apparatus may output a voltage value to the equivalent neutral point on the transformer at least twice. The short-circuit detection apparatus obtains a first voltage value and a second voltage value in a plurality of voltage regulations, and obtains a first current value of the short-circuit detection apparatus in a case in which the first voltage value is output and a second current value of the short-circuit detection apparatus in a case in which the second voltage value is output. Further, the short-circuit detection apparatus may determine ground impedances of the power system based on a difference between the first voltage value and the second voltage value and a difference between the first current value and the second current value. Herein, the ground impedances of the power system may include ground impedances Rdc1 and Rdc2 on a line between the direct current power supply (which may be a photovoltaic module or an energy storage battery) and the input end of the converter, and ground impedances Rac1, Rac2, and Rac3 on a line between the output end of the converter and a primary-side winding of the transformer. In response to the ground impedance being less than a specified threshold, the short-circuit detection apparatus may determine that the line between the direct current power supply and the input end of the converter has a short circuit to ground, or the line between the output end of the converter and the primary-side winding of the transformer has a short circuit to ground. The short-circuit detection apparatus obtains the ground impedance of the power system without an additional resistance, thereby reducing detection costs. In addition, ground impedances of both an alternating current side and a direct current side of the power system can be detected, so that an impedance short-circuit fault detection range is wider, thereby improving working reliability of the power system.

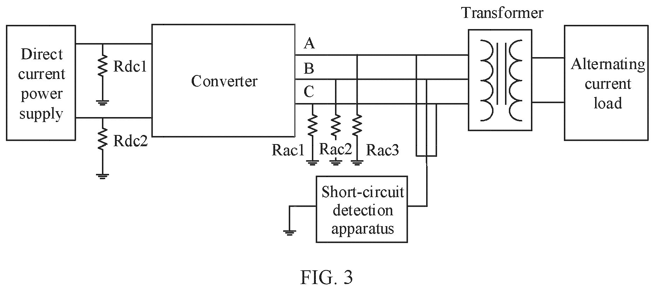

In some feasible implementations, FIG. 3 is a diagram of another structure of a power system according to this application. In the power system shown in FIG. 3, the power system may include a short-circuit detection apparatus. The short-circuit detection apparatus may be a device having a voltage source function, for example, may be an anti-PID device. This may be specifically determined based on an actual application scenario requirement, and is not limited herein. The converter may include a positive bus capacitor and a negative bus capacitor (not shown in FIG. 3) that are connected in series. A series connection point between the positive bus capacitor and the negative bus capacitor is a neutral point. The short-circuit detection apparatus may be connected to an equivalent neutral point. A ground potential difference of the equivalent neutral point is positively correlated with a ground potential difference of the neutral point. For example, the short-circuit detection apparatus may be connected to a connection end of three phases of output ends of the converter. The short-circuit detection apparatus may perform voltage regulation on an equivalent neutral point on a transformer at least twice. In other words, the short-circuit detection apparatus may output a voltage value to the equivalent neutral point on the transformer at least twice. The short-circuit detection apparatus obtains a first voltage value and a second voltage value in a plurality of voltage regulations, and obtains a first current value of the short-circuit detection apparatus in a case in which the first voltage value is output and a second current value of the short-circuit detection apparatus in a case in which the second voltage value is output. Further, the short-circuit detection apparatus may determine ground impedances of the power system based on a difference between the first voltage value and the second voltage value and a difference between the first current value and the second current value. Herein, the ground impedances of the power system may include ground impedances Rdc1 and Rdc2 on a line between the direct current power supply and an input end of the converter, and ground impedances Rac1, Rac2, and Rac3 on a line between an output end of the converter and a primary-side winding of the transformer. In response to the ground impedance being less than a specified threshold, the short-circuit detection apparatus may determine that the line between the direct current power supply and the input end of the converter has a short circuit to ground, or the line between the output end of the converter and the primary-side winding of the transformer has a short circuit to ground. The short-circuit detection apparatus obtains the ground impedance of the power system without an additional resistance, thereby reducing detection costs. In addition, ground impedances of both an alternating current side and a direct current side of the power system can be detected, so that an impedance short-circuit fault detection range is wider, thereby improving working reliability of the power system.

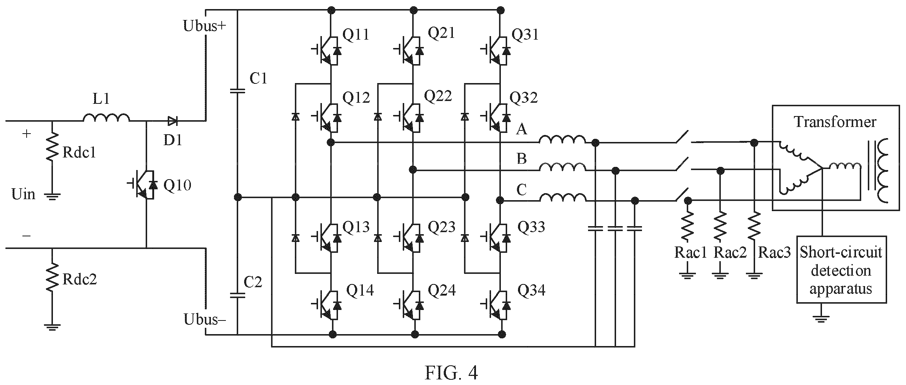

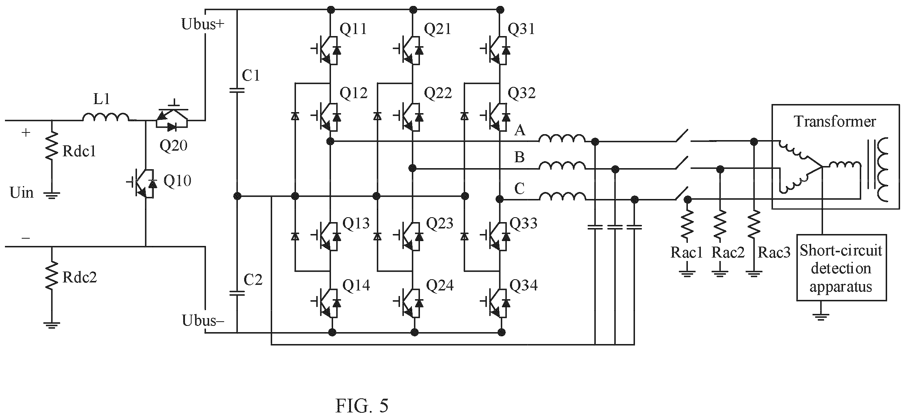

The following describes the converter and the short-circuit detection apparatus provided in embodiments of this application by using examples with reference to FIG. 2 to FIG. 11. The converter may include an inverter circuit. The inverter circuit may include a plurality of bridge arms. Each bridge arm may include four bridge arm switching transistors connected in series. The four bridge arm switching transistors connected in series are connected in parallel to two ends of the positive bus capacitor and the negative bus capacitor in the converter. FIG. 4 is a diagram of another structure of a power system according to this application. As shown in FIG. 4, the converter included in the power system in FIG. 4 may include an inverter circuit, and the inverter circuit includes a capacitor C1 and a capacitor C2 that are connected in series, and three bridge arms (a bridge arm a, a bridge arm b, and a bridge arm c). The bridge arm a, the bridge arm b, and the bridge arm c are respectively three phases A, B, and C of bridge arms. Corresponding ports of the three phases A, B, and C are respectively led out from the bridge arm a, the bridge arm b, and the bridge arm c. The bridge arm a may include four bridge arm switching transistors (which may be represented as a switching transistor Q11, a switching transistor Q12, a switching transistor Q13, and a switching transistor Q14 for ease of description) connected in series. The switching transistor Q11, the switching transistor Q12, the switching transistor Q13, and the switching transistor Q14 are successively connected in series and are connected in parallel to two ends of the capacitor C1 and the capacitor C2. A connection end of the switching transistor Q11 and the switching transistor Q12 is connected to a connection end of the switching transistor Q13 and the switching transistor Q14 through two diodes connected in series. A connection end of the two diodes connected in series is connected to a connection end (namely, a neutral point) of the capacitor C1 and the capacitor C2. In addition, a phase-A port may be led out from the connection end of the switching transistor Q12 and the switching transistor Q13, and the phase-A port may be connected to the neutral point through one inductor and one capacitor. The bridge arm b may include a switching transistor Q21, a switching transistor Q22, a switching transistor Q23, a switching transistor Q24, and two diodes. The bridge arm c may include a switching transistor Q31, a switching transistor Q32, a switching transistor Q33, a switching transistor Q34, and two diodes. It may be understood that in the converter shown in FIG. 4, circuit structures of the bridge arm b and the bridge arm c are the same as a circuit structure of the bridge arm a, and details are not described herein again. Herein, when the direct current power supply connected to the converter includes a photovoltaic string, the converter may further include a direct current conversion circuit. For example, the direct current conversion circuit is a boost circuit. The direct current conversion circuit may include a switching transistor Q10 and a diode D1 that are connected in series. The switching transistor Q10 and the diode D1 are connected in series and then are connected in parallel to the two ends of the capacitor C1 and the capacitor C2. A connection end of the switching transistor Q10 and the diode D1 is connected to one end of an inductor L1, and the other end of the inductor L1 is used as a positive electrode input end of the converter. A connection end of the switching transistor Q10 and the capacitor C2 is used as a negative electrode input end of the converter. When the direct current power supply connected to the converter includes only an energy storage battery, an input end of the inverter circuit of the converter may be connected to the energy storage battery through a bidirectional power conversion circuit. FIG. 5 is a diagram of another structure of a power system according to this application. As shown in FIG. 5, a converter included in the power system in FIG. 5 may include an inverter circuit. A circuit structure of the inverter circuit is the same as that of the inverter circuit shown in FIG. 4. Details are not described herein again. The converter may include a switching transistor Q10 and a switching transistor Q20 that are connected in series. The switching transistor Q10 and the switching transistor Q20 are connected in series and then are connected in parallel to two ends of a capacitor C1 and a capacitor C2. A connection end of the switching transistor Q10 and the switching transistor Q20 is connected to one end of an inductor L1, and the other end of the inductor L1 is used as a positive electrode input end of the converter. A connection end of the switching transistor Q10 and the capacitor C2 is used as a negative electrode input end of the converter. In the converter shown in FIG. 4 or FIG. 5, each switching transistor of the converter may be a metal-oxide-semiconductor field-effect transistor (Metal-Oxide-Semiconductor Field-Effect Transistor, MOSFET), referred to as a MOS transistor for short, or may be an insulated-gate bipolar transistor (insulated gate bipolar transistor, IGBT), or the like. This is not limited herein. Inductors connected to the phase-A port, a phase-B port, and a phase-C port of the converter are respectively used as three phases of output ends of the converter. The positive electrode input end and the negative electrode input end of the converter are configured to connect to the direct current power supply. Ground impedances of lines between the positive electrode input end and the direct current power supply and between the negative electrode input end and the direct current power supply are respectively represented as Rdc1 and Rdc2. The three phases of output ends of the converter are configured to connect to the primary-side winding of the transformer. Ground impedances of lines between the phase-A port, the phase-B port, and the phase-C port and the transformer are respectively represented as Rac1, Rac2, and Rac3.

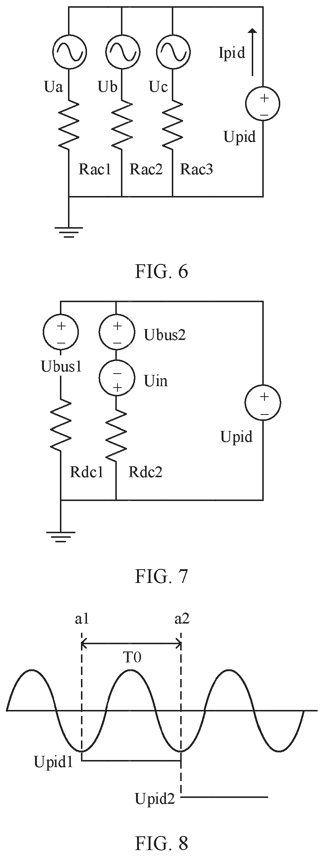

When the direct current power supply connected to the converter of the power system includes a photovoltaic string, the short-circuit detection apparatus included in the power system may be the anti-PID device. When the direct current power supply connected to the converter includes only the energy storage battery, the short-circuit detection apparatus may be another device having a voltage source function. This may be specifically determined based on an actual application scenario requirement, and is not limited herein. The short-circuit detection apparatus may be connected to an equivalent neutral point. A ground potential difference of the equivalent neutral point is positively correlated with a ground potential difference of the neutral point. For example, the short-circuit detection apparatus may be connected to a connection end of the three phases of output ends of the converter, or the short-circuit detection apparatus may be connected to an equivalent neutral point on the transformer. In the power system shown in FIG. 4, an example in which the short-circuit detection apparatus is connected to the equivalent neutral point on the transformer is used. The equivalent neutral point on the transformer may be a common contact point in which head ends of coils included in the transformer are connected together in a case of a star connection between the transformer and the converter. The short-circuit detection apparatus may perform voltage regulation on the equivalent neutral point on the transformer at least twice. In other words, the short-circuit detection apparatus may output a voltage value to the equivalent neutral point on the transformer at least twice. The short-circuit detection apparatus obtains a first voltage value and a second voltage value in a plurality of voltage regulations, and obtains a first current value of the short-circuit detection apparatus in a case in which the first voltage value is output and a second current value of the short-circuit detection apparatus in a case in which the second voltage value is output. Further, the short-circuit detection apparatus may obtain a ground impedance of the power system based on a ratio of a difference between the first voltage value and the second voltage value to a difference between the first current value and the second current value. Herein, the ground impedance of the power system may include ground impedances Rdc1 and Rdc2 on a line between the direct current power supply (which may be a photovoltaic module or an energy storage battery) and the input end of the converter, and ground impedances Rac1, Rac2, and Rac3 on a line between the output end of the converter and the primary-side winding of the transformer. FIG. 6 is a schematic of an equivalent circuit on an alternating current side of a power system according to this application. As shown in FIG. 6, the alternating current side of the power system may include three alternating current voltage sources equivalent to the three phases of output ends of the converter, which are respectively an alternating current voltage source Ua, an alternating current voltage source Ub, and an alternating current voltage source Uc that are output from the phase-A port, the phase-B port, and the phase-C port. After being connected in series to the ground impedances Rac1, Rac2, and Rac3 respectively, the alternating current voltage source Ua, the alternating current voltage source Ub, and the alternating current voltage source Uc are connected in parallel to two ends of a voltage source Upid equivalent to the short-circuit detection apparatus. FIG. 7 is a schematic of an equivalent circuit on a direct current side of a power system according to this application. As shown in FIG. 7, the direct current side of the power system may include direct current voltage sources Ubus1 and Ubus2 equivalent to half of a bus voltage between a positive direct current bus and a negative direct current bus of the converter, and a direct current voltage source Uin equivalent to a voltage at the input end of the converter. The direct current voltage source Ubus1 and the ground impedance Rdc1 are connected in series and then are connected in parallel to two ends of a voltage source Upid equivalent to the short-circuit detection apparatus. The direct current voltage source Ubus2, the direct current voltage source Uin, and the ground impedance Rdc2 are connected in series and then are connected in parallel to the two ends of the voltage source Upid equivalent to the short-circuit detection apparatus.

In some feasible implementations, the short-circuit detection apparatus may output the first voltage value to the equivalent neutral point at a first moment, and output the second voltage value to the equivalent neutral point at a second moment. A time interval between the first moment and the second moment is an integer multiple of a cycle of an output alternating current voltage of the converter. Alternatively, when the converter is on-grid, the time interval between the first moment and the second moment may be an integer multiple of a cycle of an alternating current power grid. The short-circuit detection apparatus may obtain the ground impedance of the power system based on the ratio of the difference between the first voltage value and the second voltage value to the difference between the first current value and the second current value. Specifically, the converter shown in FIG. 4 is used as an example. The short-circuit detection apparatus may output a first voltage value (which may be represented as Upid1 for ease of description) to the equivalent neutral point on the transformer at the first moment, output a second voltage value (which may be represented as Upid2 for ease of description) to the equivalent neutral point on the transformer at the second moment after an interval of an integer multiple of a cycle of an output alternating current voltage of the converter, and obtain a first current value (which may be represented as Ipid1 for ease of description) of the short-circuit detection apparatus in a case in which Upid1 is output and a second current value (which may be represented as Ipid2 for ease of description) of the short-circuit detection apparatus in a case in which Upid2 is output. FIG. 8 is a diagram of another output voltage waveform of a short-circuit detection apparatus according to this application. As shown in FIG. 8, the short-circuit detection apparatus may output Upid1 at a1, and output Upid2 at a2 after a cycle T0 of the output alternating current voltage of the converter. A sinusoidal waveform in FIG. 8 may be an alternating current voltage waveform output by any one of the phase-A port, the phase-B port, or the phase-C port of the converter. For example, the sinusoidal waveform is an alternating current voltage waveform output by the phase-A port. Magnitudes of phase-A voltages corresponding to a moment at which the short-circuit detection apparatus outputs Upid1 and a moment at which the Upid2 is output are the same. Because magnitudes of alternating current voltages output by the phase-A port at moments a1 and a2 are the same, when a difference between Upid2 and Upid1 is calculated, the alternating current voltages output by the phase-A port may be offset. Similarly, when a difference between Ipid2 and Ipid1 is calculated, the alternating currents output by the phase-A port may also be offset, and alternating current voltages and alternating currents output by the phase-B port and the phase-C port are similar. It may be understood that the alternating current voltage source Ua, the alternating current voltage source Ub, and the alternating current voltage source Uc in FIG. 6 may be equivalent to conducting wires in a case of voltage regulation in FIG. 8.

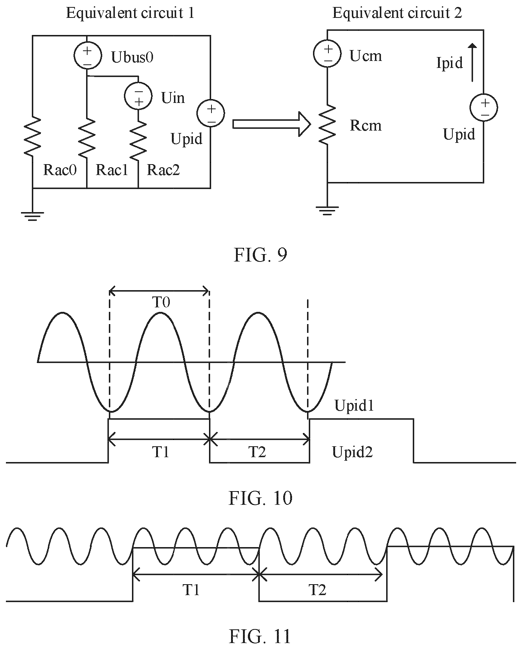

FIG. 9 is a schematic of equivalent circuits on an alternating current side and a direct current side of a power system according to this application. An equivalent circuit 1 included in FIG. 9 may be a superposition of the equivalent circuit on the alternating current side shown in FIG. 6 and the equivalent circuit on the direct current side shown in FIG. 7. The equivalent circuit 1 may include Rac0, and Rac0 is a parallel equivalent impedance of the ground impedances Rac1, Rac2, and Rac3 in FIG. 6. Rac0 is connected in parallel to two ends of a direct current voltage source Ubus0 and a ground impedance Rdc1 to that are connected in series. The direct current voltage source Ubus0 is a direct current voltage source equivalent to half of a bus voltage between a positive direct current bus and a negative direct current bus of the converter. A connection end of the direct current voltage source Ubus0 and a ground impedance Rdc1 is grounded through a direct current voltage source Uin and a ground impedance Rdc2 that are connected in series. Based on the Thevenin's theorem, the equivalent circuit 1 may be equivalent to a simplified equivalent circuit 2. The equivalent circuit 2 includes a direct current voltage source Ucm and a ground impedance Rem that are connected in series. The direct current voltage source Ucm is an equivalent direct current voltage source of the direct current voltage source Ubus0 and the direct current voltage source Uin in the equivalent circuit 1. The ground impedance Rem is an equivalent impedance of the ground impedances Rac1, Rac2, and Rac3 superposed with the parallel ground impedances Rdc1 and Rdc2. That is, the ground impedance Rem is an equivalent ground impedance of the direct current side and the alternating current side of the power system. The short-circuit detection apparatus may output Upid1 to the equivalent neutral point at the first moment, output Upid2 to the equivalent neutral point at the second moment after an interval of an integer multiple of a cycle of an output alternating current voltage of the converter, and obtain Ipid1 of the short-circuit detection apparatus in a case in which Upid2 is output and Ipid1 of the short-circuit detection apparatus in a case in which Upid2 is output. As shown in FIG. 9, the equivalent ground impedance Rem on the direct current side and the alternating current side of the power system may be expressed as:

$$Rcm = \frac{Upid2 - Upid1}{Ipid2 - Ipid2}$$

Herein, a time interval between a moment at which the short-circuit detection apparatus outputs the first voltage value and a moment at which the short-circuit detection apparatus outputs the second voltage value is an integer multiple of a cycle of an output alternating current voltage of the converter. Therefore, interference from an output voltage of the converter or interference from an output voltage and current of a grid can be offset, thereby further improving accuracy of obtaining the ground impedance of the power system by the short-circuit detection apparatus. In response to the ground impedance of the power system being less than a specified threshold, the short-circuit detection apparatus may determine that the line between the direct current power supply and the input end of the converter has a short circuit to ground, or the line between the output end of the converter and the primary-side winding of the transformer has a short circuit to ground. The short-circuit detection apparatus obtains the ground impedance of the power system without an additional resistance, thereby reducing detection costs. In addition, the ground impedances of both the alternating current side and the direct current side of the power system can be detected, so that an impedance short-circuit fault detection range is wider, thereby improving working reliability of the power system.

In some feasible implementations, the short-circuit detection apparatus may output an alternating current voltage. High-level duration of the alternating current voltage may be a first time interval, and low-level duration of the alternating current voltage may be a second time interval. The short-circuit detection apparatus may obtain the first voltage value output in a period in which the alternating current voltage is at a high level and a first current average value of the short-circuit detection apparatus in a case in which the first voltage value is output, and obtain the second voltage value output in a period in which the alternating current voltage is at a low level and a second current average value of the short-circuit detection apparatus in a case in which the second voltage value is output. The first time interval and the second time interval are integer multiples of a cycle of an output alternating current voltage of the converter. Specifically, the converter shown in FIG. 4 is used as an example. The short-circuit detection apparatus may output the alternating current voltage to the equivalent neutral point on the transformer. The high-level duration of the alternating current voltage may be the first time interval (which may be represented as T1 for ease of description). The low-level duration of the alternating current voltage may be the second time interval (which may be represented as T2 for ease of description). T1 and T2 are integer multiples of a cycle T0 of the output alternating current voltage of the converter. FIG. 10 is a diagram of another output voltage waveform of a short-circuit detection apparatus according to this application. As shown in FIG. 10, the short-circuit detection apparatus may output an alternating current voltage of a rectangular wave with duration T1 at a high level and duration T2 at a low level, and duration T1 and T2 may be one cycle T0 of the output alternating current voltage of the converter. A sinusoidal waveform in FIG. 10 may be an alternating current voltage waveform output by any one of the phase-A port, the phase-B port, or the phase-C port of the converter. For example, the sinusoidal waveform is an alternating current voltage waveform output by the phase-A port. The short-circuit detection apparatus may obtain the first voltage value (which may be represented as Upid1 for ease of description) output in a period in which the alternating current voltage is at a high level and a first current average value of the short-circuit detection apparatus in a case in which Upid1 is output, and obtain the second voltage value (which may be represented as Upid2 for ease of description) output in a period in which the alternating current voltage is at a low level and a second current average value of the short-circuit detection apparatus in a case in which the second voltage value is output. Durations T1 and T2 are a cycle T0 of the output alternating current voltage of the converter. That is, durations T1 and T2 are a cycle of an output alternating current voltage of the phase-A port. In this case, the short-circuit detection apparatus may obtain a superposed average value of the voltage output by the short-circuit detection apparatus and the alternating current voltage output by the phase-A port in T1. The alternating current voltage output by the phase-A port may be offset, to obtain the foregoing Upid1 . The short-circuit detection apparatus may obtain a superposed average value of the voltage output by the short-circuit detection apparatus and the alternating current voltage output by the phase-A port in T2. The alternating current voltage output by the phase-A port may be offset, to obtain the foregoing Upid2. Similarly, the short-circuit detection apparatus may obtain a superposed average value of a current output by the short-circuit detection apparatus and an alternating current output by the phase-A port in T1. The alternating current output by the phase-A port may be offset, to obtain the first current average value as the first current value (which may be represented as Ipid1 for ease of description). The short-circuit detection apparatus may obtain a superposed average value of the current output by the short-circuit detection apparatus and the alternating current output by the phase-A port in T2. The alternating current output by the phase-A port may be offset, to obtain the second current average value as the second current value (which may be represented as Ipid2 for ease of description). Alternating current voltages and alternating currents output by the phase-B port and the phase-C port are similar. It may be understood that the alternating current voltage source Ua, the alternating current voltage source Ub, and the alternating current voltage source Uc in FIG. 6 may be equivalent to conducting wires in a case of voltage regulation in FIG. 10. Similarly, based on the equivalent circuit 1 and the equivalent circuit 2 shown in FIG. 9, it may be learned that the equivalent ground impedance of the direct current side and the alternating current side of the power system is a ground impedance obtained based on a ratio of a difference between the first voltage value and the second voltage value to a difference between the first current average value and the second current average value. Herein, both the high-level duration and the low-level duration of the alternating current voltage output by the short-circuit detection apparatus are integer multiples of a cycle of an output alternating current voltage of the converter. Therefore, interference from an output voltage of the converter or interference from an output voltage and current of a grid can be offset, thereby further improving accuracy of obtaining the ground impedance of the power system by the short-circuit detection apparatus. In response to the ground impedance of the power system being less than a specified threshold, the short-circuit detection apparatus may determine that the line between the direct current power supply and the input end of the converter has a short circuit to ground, or the line between the output end of the converter and the primary-side winding of the transformer has a short circuit to ground. The short-circuit detection apparatus obtains the ground impedance of the power system without an additional resistance, thereby reducing detection costs. In addition, the ground impedances of both the alternating current side and the direct current side of the power system can be detected, so that an impedance short-circuit fault detection range is wider, thereby improving working reliability of the power system.

In some feasible implementations, an alternating current voltage waveform output by the short-circuit detection apparatus is a square wave, a trapezoidal wave, or the like. This may be specifically determined based on an actual application scenario requirement, and is not limited herein. Both the high-level duration and the low-level duration of the alternating current voltage are integer multiples of a cycle of an output alternating current voltage of the converter.

In some feasible implementations, the alternating current voltage waveform output by the short-circuit detection apparatus may be superposition of the square wave or the trapezoidal wave and another periodically fluctuating signal. FIG. 11 is a diagram of another output voltage waveform of a short-circuit detection apparatus according to this application. As shown in FIG. 11, the short-circuit detection apparatus may output an alternating current voltage of a rectangular wave with duration T1 at a high level and duration T2 at a low level. The rectangular wave may be superposed with another sinusoidal wave. Durations T1 and T2 are equal to an integer multiple of a cycle of the sinusoidal wave. In the alternating current voltage waveform, durations T1 and T2 are equal to an integer multiple of a cycle of a superposed sinusoidal wave. In this case, the short-circuit detection apparatus obtains a superposed average value of the voltage output by the short-circuit detection apparatus and an alternating current voltage output by a port of any phase of the converter in T1 or T2. The superposed sinusoidal wave and the alternating current voltage output by the port of any phase can be offset, and subsequent calculation of the ground impedance is not affected.

In some feasible implementations, when the short-circuit detection apparatus is connected to the equivalent neutral point on the transformer, in response to the ground impedance being less than a specified threshold, the short-circuit detection apparatus may determine, when the converter stops working, that the line between the output end of the converter and the primary-side winding of the transformer has a short circuit to ground.

In some feasible implementations, in response to the ground impedance being less than a specified threshold, the short-circuit detection apparatus may report or send ground impedance abnormality fault information. Specifically, a controller may send, to an independent communication apparatus (for example, a mobile phone or another portable communication device), fault information about a short circuit to ground, so that the communication apparatus prompts, by using an image, a sound, or the like, that a short circuit to ground occurs in the power system. Alternatively, the controller may send, to an alarm device installed in the power system, the fault information about a short circuit to ground, so that the alarm device prompts that the short circuit to ground occurs by using an image, a sound, or the like. This may be specifically determined based on an actual application scenario requirement, and is not limited herein.

In some feasible implementations, the bridge arm a in the converter may include four bridge arm switching transistors (which may be represented as a switching transistor Q11, a switching transistor Q12, a switching transistor Q13, and a switching transistor Q14 for ease of description) connected in series. The switching transistor Q11, the switching transistor Q12, the switching transistor Q13, and the switching transistor Q14 are successively connected in series and are connected in parallel to two ends of the capacitor C1 and the capacitor C2. A connection end of the switching transistor Q11 and the switching transistor Q12 is connected to a connection end of the switching transistor Q13 and the switching transistor Q14 through two switching transistors (a switching transistor Q15 and a switching transistor Q16) connected in series. A connection end of the switching transistor Q15 and the switching transistor Q16 is connected to a neutral point, and the phase-A port may be led out from a connection end of the switching transistor Q12 and the switching transistor Q13. Circuit structures of the bridge arm b and the bridge arm c are the same as a circuit structure of the bridge arm a, and details are not described herein again.

In some feasible implementations, the bridge arm a in the converter may include a first bridge arm switching transistor and a second bridge arm switching transistor (which may be represented as the switching transistor Q11 and the switching transistor Q12 for ease of description) connected in series. The switching transistor Q11 and the switching transistor Q12 may be connected in parallel to two ends of the capacitor C1 and the capacitor C2 that are connected in series in the power converter. The phase-A port may be led out from the connection end of the switching transistor Q11 and the switching transistor Q12. In addition, the connection end of the switching transistor Q11 and the switching transistor Q12 may be connected to a series connection point of the capacitor C1 and the capacitor C2 through an additional third bridge arm switching transistor and an additional fourth bridge arm switching transistor (which may be represented as the switching transistor Q13 and the switching transistor Q14 for ease of description) connected in series. Circuit structures of the bridge arm b and the bridge arm c are the same as a circuit structure of the bridge arm a, and details are not described herein again.

## Claims

1. A power system, comprising a converter and a short-circuit detection apparatus, wherein an input end of the converter is configured to connect to a direct current power supply, an output end of the converter is configured to be coupled to an alternating current load, the converter comprises a positive bus capacitor and a negative bus capacitor that are connected in series, a series connection point between the positive bus capacitor and the negative bus capacitor is a neutral point, wherein the power system is **characterised in that**

   the short-circuit detection apparatus is connected to an equivalent neutral point, a ground potential difference of the equivalent neutral point is positively correlated with a ground potential difference of the neutral point, and the equivalent neutral point comprises a connection end of three phases of output ends of the converter;
   the short-circuit detection apparatus is configured to: output a first voltage value to the equivalent neutral point, obtain a first current value of the short-circuit detection apparatus in a case in which the first voltage value is output, output a second voltage value to the equivalent neutral point, and obtain a second current value of the short-circuit detection apparatus in a case in which the second voltage value is output; and
   the short-circuit detection apparatus is configured to: in response to a ratio of a difference between the first voltage value and the second voltage value to a difference between the first current value and the second current value being less than a specified threshold, report or send ground impedance abnormality fault information.

2. The power system according to claim 1, wherein a ground impedance of the power system is positively correlated with the ratio of the difference between the first voltage value and the second voltage value to the difference between the first current value and the second current value, and the short-circuit detection apparatus is configured to: in response to the ratio of the difference between the first voltage value and the second voltage value to the difference between the first current value and the second current value being less than the specified threshold, determine that the ground impedance is less than the specified threshold, and report or send the ground impedance abnormality fault information.

3. The power system according to claim 1 or 2, wherein the power system comprises a transformer, an output end of the converter is connected to a primary-side winding of the transformer, a secondary-side winding of the transformer is configured to connect to the alternating current load, and the short-circuit detection apparatus is connected to an equivalent neutral point on the transformer.

4. The power system according to any one of claims 1 to 3, wherein the short-circuit detection apparatus is configured to output the first voltage value to the equivalent neutral point at a first moment, and output the second voltage value to the equivalent neutral point at a second moment, wherein a time interval between the first moment and the second moment is an integer multiple of a cycle of an output alternating current voltage of the converter.

5. The power system according to any one of claims 1 to 3, wherein the short-circuit detection apparatus is configured to: output an alternating current voltage to the equivalent neutral point, wherein high-level duration of the alternating current voltage is a first time interval, and low-level duration of the alternating current voltage is a second time interval; obtain the first voltage value output by the short-circuit detection apparatus in a period in which the alternating current voltage is at a high level and a first current average value of the short-circuit detection apparatus in a case in which the first voltage value is output; and obtain the second voltage value output by the short-circuit detection apparatus in a period in which the alternating current voltage is at a low level and a second current average value of the short-circuit detection apparatus in a case in which the second voltage value is output, wherein the first time interval and the second time interval are integer multiples of a cycle of an output alternating current voltage of the converter; and
obtain the ground impedance based on a ratio of the difference between the first voltage value and the second voltage value to a difference between the first current average value and the second current average value.

6. The power system according to claim 5, wherein an alternating current voltage waveform output by the short-circuit detection apparatus is a square wave or a trapezoidal wave.

7. The power system according to claim 6, wherein the alternating current voltage waveform output by the short-circuit detection apparatus is superposition of the square wave and a periodically fluctuating signal, or superposition of the trapezoidal wave and the periodically fluctuating signal, wherein an integer multiple of a cycle of the periodically fluctuating signal is equal to the first time interval and the second time interval.

8. The power system according to any one of claims 1 to 7, wherein the converter comprises an inverter circuit, and the inverter circuit comprises at least one bridge arm and the positive bus capacitor and the negative bus capacitor that are connected in series, wherein the bridge arm is connected in parallel to two ends of the positive bus capacitor and the negative bus capacitor that are connected in series, one end of the bridge arm is connected to a connection end of the positive bus capacitor and the negative bus capacitor, and the other end of the bridge arm is configured to be coupled to the alternating current load.

9. The power system according to claim 8, wherein the converter comprises a direct current conversion circuit, an input end of the direct current conversion circuit is configured to connect to the direct current power supply, and a positive electrode output end and a negative electrode output end of the direct current conversion circuit are respectively connected to the two ends of the positive bus capacitor and the negative bus capacitor that are connected in series.

10. A method for detecting a ground impedance, wherein the method comprises:

outputting a first voltage value to an equivalent neutral point, obtaining a first current value that is output in a case in which the first voltage value is output, outputting a second voltage value to the equivalent neutral point, and obtaining a second current value that is output in a case in which the second voltage value is output; and in response to a ratio of a difference between the first voltage value and the second voltage value to a difference between the first current value and the second current value being less than a specified threshold, reporting or sending ground impedance abnormality fault information, wherein
a ground potential difference of the equivalent neutral point is positively correlated with a ground potential difference of a neutral point, the neutral point is a series connection point between a positive bus capacitor and a negative bus capacitor in a converter, an input end of the converter is configured to connect to a direct current power supply, and an output end of the converter is configured to be coupled to an alternating current load.

11. The method according to claim 10, wherein the ground impedance is positively correlated with the ratio of the difference between the first voltage value and the second voltage value to the difference between the first current value and the second current value, and the method comprises:
in response to the ratio of the difference between the first voltage value and the second voltage value to the difference between the first current value and the second current value being less than the specified threshold, determining that the ground impedance is less than the specified threshold, and reporting or sending the ground impedance abnormality fault information.

12. The method according to claim 11, wherein the method comprises:
outputting the first voltage value to the equivalent neutral point at a first moment, and outputting the second voltage value to the equivalent neutral point at a second moment, wherein a time interval between the first moment and the second moment is an integer multiple of a cycle of an output alternating current voltage of the converter.

13. The method according to claim 11, wherein the method comprises:

outputting an alternating current voltage to the equivalent neutral point, wherein high-level duration of the alternating current voltage is a first time interval, and low-level duration of the alternating current voltage is a second time interval; obtaining the first voltage value output to the equivalent neutral point in a period in which the alternating current voltage is at a high level and a first current average value output in a case in which the first voltage value is output; and obtaining the second voltage value output to the equivalent neutral point in a period in which the alternating current voltage is at a low level and a second current average value output in a case in which the second voltage value is output, wherein the first time interval and the second time interval are integer multiples of a cycle of an output alternating current voltage of the converter; and obtaining the ground impedance based on a ratio of the difference between the first voltage value and the second voltage value to a difference between the first current average value and the second current average value.

14. The method according to claim 13, wherein:

an alternating current voltage waveform output to the equivalent neutral point is a square wave or a trapezoidal wave; or the alternating current voltage waveform output to the equivalent neutral point is superposition of the square wave and a periodically fluctuating signal, or superposition of the trapezoidal wave and the periodically fluctuating signal, wherein an integer multiple of a cycle of the periodically fluctuating signal is equal to the first time interval and the second time interval.

15. The method according to claim 10 or 11, wherein, the output end of the converter is configured to connect to a primary-side winding of a transformer, and a short-circuit detection apparatus is connected to an equivalent neutral point on the transformer.

**Patentansprüche**

1. Energiesystem, einen Wandler und eine Kurzschluss-Erkennungsvorrichtung umfassend, wobei ein Eingangsende des Wandlers dafür konfiguriert ist, mit einer Gleichstrom-Energieversorgung verbunden zu sein, ein Ausgangsende des Wandlers dafür konfiguriert ist, mit einer Wechselstromlast gekoppelt zu sein, der Wandler einen positiven Buskondensator und einen negativen Buskondensator umfasst, die in Reihe geschaltet sind, ein Reihenverbindungspunkt zwischen dem positiven Buskondensator und dem negativen Buskondensator ein neutraler Punkt ist, wobei das Energiesystem **dadurch gekennzeichnet ist, dass**

die Kurzschluss-Erkennungsvorrichtung mit einem äquivalenten neutralen Punkt gekoppelt ist, wobei eine Differenz des Erdpotentials des äquivalenten neutralen Punkts positiv mit einer Differenz des Erdpotentials des neutralen Punkts korreliert ist und der äquivalente neutrale Punkt ein Verbindungsende von drei Phasen von Ausgangsenden des Wandlers umfasst; die Kurzschluss-Erkennungsvorrichtung für Folgendes konfiguriert ist: Ausgeben eines ersten Spannungswertes an den äquivalenten neutralen Punkt, Erhalten eines ersten Stromwertes der Kurzschluss-Erkennungsvorrichtung, wenn der erste Spannungswert ausgegeben wird, Ausgeben eines zweiten Spannungswertes an den äquivalenten neutralen Punkt und Erhalten eines zweiten Stromwertes der Kurzschluss-Erkennungsvorrichtung, wenn der zweite Spannungswert ausgegeben wird; und die Kurzschluss-Erkennungsvorrichtung für Folgendes konfiguriert ist: in Reaktion darauf, dass ein Verhältnis einer Differenz zwischen dem ersten Spannungswert und dem zweiten Spannungswert zu einer Differenz zwischen dem ersten Stromwert und dem zweiten Stromwert kleiner als ein spezifizierter Schwellenwert ist, Melden oder Senden von Informationen über einen Erdimpedanz-Anomaliefehler.

2. Energiesystem nach Anspruch 1, wobei eine Erdimpedanz des Energiesystems positiv mit dem Verhältnis der Differenz zwischen dem ersten Spannungswert und dem zweiten Spannungswert zu der Differenz zwischen dem ersten Stromwert und dem zweiten Stromwert korreliert ist und die Kurzschluss-Erkennungsvorrichtung für Folgendes konfiguriert ist: in Reaktion darauf, dass das Verhältnis der Differenz zwischen dem ersten Spannungswert und dem zweiten Spannungswert zu der Differenz zwischen dem ersten Stromwert und dem zweiten Stromwert kleiner als der spezifizierte Schwellenwert ist, Bestimmen, dass die Erdimpedanz kleiner als der spezifizierte Schwellenwert ist, und Melden oder Senden von Informationen über einen Erdimpedanz-Anomaliefehler.

3. Energiesystem nach Anspruch 1 oder 2, wobei das Energiesystem einen Transformator umfasst, wobei ein Ausgangsende des Wandlers mit einer primärseitigen Wicklung des Transformators verbunden ist, eine sekundärseitige Wicklung des Transformators dafür konfiguriert ist, mit der Wechselstromlast verbunden zu sein, und die Kurzschluss-Erkennungsvorrichtung mit einem äquivalenten neutralen Punkt an dem Transformator verbunden ist.

4. Energiesystem nach einem der Ansprüche 1 bis 3, wobei die Kurzschluss-Erkennungsvorrichtung dafür konfiguriert ist, den ersten Spannungswert in einem ersten Moment an den äquivalenten neutralen Punkt auszugeben und den zweiten Spannungswert in einem zweiten Moment an den äquivalenten neutralen Punkt auszugeben, wobei ein Zeitintervall zwischen dem ersten Moment und dem zweiten Moment ein ganzzahliges Mehrfaches eines Zyklus einer ausgegebenen Wechselstromspannung des Wandlers ist.

5. Energiesystem nach einem der Ansprüche 1 bis 3, wobei die Kurzschluss-Erkennungsvorrichtung für Folgendes konfiguriert ist: Ausgeben einer Wechselstromspannung an den äquivalenten neutralen Punkt, wobei die Dauer eines hohen Pegels der Wechselstromspannung ein erstes Zeitintervall ist und die Dauer eines niedrigem Pegels der Wechselstromspannung ein zweites Zeitintervall ist; Erhalten des ersten Spannungswertes, der durch die Kurzschluss-Erkennungsvorrichtung in einer Periode ausgegeben wird, in der die Wechselstromspannung einen hohen Pegel aufweist, und eines ersten durchschnittlichen Stromwertes der Kurzschluss-Erkennungsvorrichtung, wenn der erste Spannungswert ausgegeben wird; und Erhalten des zweiten Spannungswertes, der durch die Kurzschluss-Erkennungsvorrichtung in einer Periode ausgegeben wird, in der die Wechselstromspannung einen niedrigen Pegel aufweist, und eines zweiten durchschnittlichen Stromwertes der Kurzschluss-Erkennungsvorrichtung, wenn der zweite Spannungswert ausgegeben wird, wobei das erste Zeitintervall und das zweite Zeitintervall ganzzahlige Mehrfache eines Zyklus einer ausgegebenen Wechselstromspannung des Wandlers sind; und

Erhalten einer Erdimpedanz, basierend auf einem Verhältnis der Differenz zwischen dem ersten Spannungswert und dem zweiten Spannungswert zu einer Differenz zwischen dem ersten durchschnittlichen Stromwert und dem zweiten durchschnittlichen Stromwert.

6. Energiesystem nach Anspruch 5, wobei eine Wellenform der Wechselstromspannung, die durch die Kurzschluss-Erkennungsvorrichtung ausgegeben wird, eine Rechteckwelle oder eine Trapezwelle ist.

7. Energiesystem nach Anspruch 6, wobei die Wellenform der Wechselstromspannung, die durch die Kurzschluss-Erkennungsvorrichtung ausgegeben wird, eine Überlagerung der Rechteckwelle und eines periodisch fluktuierenden Signals ist oder eine Überlagerung der Trapezwelle und des periodisch fluktuierenden Signals, wobei ein ganzzahliges Mehrfaches eines Zyklus des periodisch fluktuierenden Signals gleich dem ersten Zeitintervall und dem zweiten Zeitintervall ist.

8. Energiesystem nach einem der Ansprüche 1 bis 7, wobei der Wandler eine Wandlerschaltung umfasst und die Wandlerschaltung mindestens einen Brückenarm umfasst, und den positiven Buskondensator und den negativen Buskondensator, die in Reihe geschaltet sind, wobei der Brückenarm mit zwei Enden des positiven Buskondensators und des negativen Buskondensators, die in Reihe geschaltet sind, parallel geschaltet ist, wobei ein Ende des Brückenarms mit einem Verbindungsende des positiven Buskondensators und des negativen Buskondensators verbunden ist und das andere Ende des Brückenarms dafür konfiguriert ist, mit der Wechselstromlast verbunden zu sein.

9. Energiesystem nach Anspruch 8, wobei der Wandler eine Gleichstrom-Umwandlungsschaltung umfasst, wobei ein Eingangsende der Gleichstrom-Umwandlungsschaltung dafür konfiguriert ist, mit der Gleichstrom-Energieversorgung verbunden zu sein, und ein Ausgangsende der positiven Elektrode und ein Ausgangsende der negativen Elektrode der Gleichstrom-Umwandlungsschaltung entsprechend mit den zwei Enden des positiven Buskondensators und des negativen Buskondensators, die in Reihe geschaltet sind, verbunden sind.

10. Verfahren zum Erkennen einer Erdimpedanz, wobei das Verfahren Folgendes umfasst: Ausgeben eines ersten Spannungswertes an einen äquivalenten neutralen Punkt, Erhalten eines ersten Stromwertes, der ausgegeben wird, wenn der erste Spannungswert ausgegeben wird, Ausgeben eines zweiten Spannungswertes an den äquivalenten neutralen Punkt und Erhalten eines zweiten Stromwertes, der ausgegeben wird, wenn der zweite Spannungswert ausgegeben wird; und

in Reaktion darauf, dass ein Verhältnis einer Differenz zwischen dem ersten Spannungswert und dem zweiten Spannungswert zu einer Differenz zwischen dem ersten Stromwert und dem zweiten Stromwert kleiner als ein spezifizierter Schwellenwert ist, Melden oder Senden von Informationen über einen Erdimpedanz-Anomaliefehler, wobei
eine Differenz des Erdpotentials des äquivalenten neutralen Punkts positiv mit einer Differenz des Erdpotentials des neutralen Punkts korreliert ist, der neutrale Punkt ein Reihenschaltungspunkt zwischen einem positiven Buskondensator und einem negativen Buskondensator in dem Wandler ist, ein Eingangsende des Wandlers dafür konfiguriert ist, mit einer Gleichstrom-Energieversorgung verbunden zu sein, und ein Ausgangsende des Wandlers dafür konfiguriert ist, mit einer Wechselstromlast gekoppelt zu sein.

11. Verfahren nach Anspruch 10, wobei die Erdimpedanz positiv mit dem Verhältnis der Differenz zwischen dem ersten Spannungswert und dem zweiten Spannungswert zu der Differenz zwischen dem ersten Stromwert und dem zweiten Stromwert korreliert ist und das Verfahren Folgendes umfasst:
in Reaktion darauf, dass das Verhältnis der Differenz zwischen dem ersten Spannungswert und dem zweiten Spannungswert zu der Differenz zwischen dem ersten Stromwert und dem zweiten Stromwert kleiner als der spezifizierte Schwellenwert ist, Bestimmen, dass die Erdimpedanz kleiner als der spezifizierte Schwellenwert ist, und Melden oder Senden der Informationen über einen Erdimpedanz-Anomaliefehler.

12. Verfahren nach Anspruch 11, wobei das Verfahren Folgendes umfasst:
Ausgeben des ersten Spannungswertes an den äquivalenten neutralen Punkt in einem ersten Moment und Ausgeben des zweiten Spannungswertes an den äquivalenten neutralen Punkt in einem zweiten Moment, wobei ein Zeitintervall zwischen dem ersten Moment und dem zweiten Moment ein ganzzahliges Mehrfaches eines Zyklus einer ausgegebenen Wechselstromspannung des Wandlers ist.

13. Verfahren nach Anspruch 11, wobei das Verfahren Folgendes umfasst:

Ausgeben einer Wechselstromspannung an den äquivalenten neutralen Punkt, wobei die Dauer eines hohen Pegels der Wechselstromspannung ein erstes Zeitintervall ist und die Dauer eines niedrigem Pegels der Wechselstromspannung ein zweites Zeitintervall ist; Erhalten des ersten Spannungswertes, der an den äquivalenten neutralen Punkt in einer Periode ausgegeben wird, in der die Wechselstromspannung einen hohen Pegel aufweist, und eines ersten durchschnittlichen Stromwertes, wenn der erste Spannungswert ausgegeben wird; und Erhalten des zweiten Spannungswertes, der an den äquivalenten neutralen Punkt in einer Periode ausgegeben wird, in der die Wechselstromspannung einen niedrigen Pegel aufweist, und eines zweiten durchschnittlichen Stromwertes, der ausgegeben wird, wenn der zweite Spannungswert ausgegeben wird, wobei das erste Zeitintervall und das zweite Zeitintervall ganzzahlige Mehrfache eines Zyklus einer ausgegebenen Wechselstromspannung des Wandlers sind; und
Erhalten der Erdimpedanz, basierend auf einem Verhältnis der Differenz zwischen dem ersten Spannungswert und dem zweiten Spannungswert zu einer Differenz zwischen dem ersten durchschnittlichen Stromwert und dem zweiten durchschnittlichen Stromwert.

14. Verfahren nach Anspruch 13, wobei:

die Wellenform der Wechselstromspannung, die an den gleichwertigen neutralen Punkt ausgegeben wird, eine Rechteckwelle oder eine Trapezwelle ist; oder
die Wellenform der Wechselstromspannung, die an den gleichwertigen neutralen Punkt ausgegeben wird, eine Überlagerung der Rechteckwelle und eines periodisch fluktuierenden Signals ist oder eine Überlagerung der Trapezwelle und des periodisch fluktuierenden Signals, wobei ein ganzzahliges Mehrfaches eines Zyklus des periodisch fluktuierenden Signals gleich dem ersten Zeitintervall und dem zweiten Zeitintervall ist.

**15.** Verfahren nach Anspruch 10 oder 11, wobei das Ausgabeende des Wandlers dafür konfiguriert ist, mit einer primärseitigen Wicklung eines Transformators verbunden zu sein, und eine Kurzschluss-Erkennungsvorrichtung mit einem äquivalenten neutralen Punkt an dem Transformator verbunden ist.

## Revendications

**1.** Système d'alimentation, comportant un convertisseur et un appareil de détection de court-circuit, une extrémité d'entrée du convertisseur étant configurée de façon à connecter à une alimentation en courant continu, une extrémité de sortie du convertisseur étant configurée de façon à être couplée à une charge en courant alternatif, le convertisseur comportant un condensateur de bus positif et un condensateur de bus négatif qui sont connectés en série, un point de connexion en série entre le condensateur de bus positif et le condensateur de bus négatif étant un point neutre, le système d'alimentation étant **caractérisé en ce que**

l'appareil de détection de court-circuit est connecté à un point neutre équivalent, une différence de potentiel de masse du point neutre équivalent est positivement corrélée avec une différence de potentiel de masse du point neutre, et le point neutre équivalent comporte une extrémité de connexion de trois phases des extrémités de sortie du convertisseur ; l'appareil de détection de court-circuit est configuré de façon à : fournir une première valeur de tension au point neutre équivalent, obtenir une première valeur de courant de l'appareil de détection de court-circuit dans le cas où la première valeur de tension est fournie, fournir une deuxième valeur de tension au point neutre équivalent, et à obtenir une deuxième valeur de courant de l'appareil de détection de court-circuit dans le cas où la deuxième valeur de tension est fournie ; et **en ce que** l'appareil de détection de court-circuit est configuré de façon à : en réponse au fait qu'un rapport entre une différence entre la première valeur de tension et la deuxième valeur de tension et une différence entre la première valeur de courant et la deuxième valeur de courant est moins qu'un seuil spécifié, signaler ou envoyer des informations de défaut d'anomalie de l'impédance de masse.

**2.** Système d'alimentation selon la revendication 1, dans lequel une impédance de masse du système d'alimentation est positivement corrélée avec le rapport entre la différence entre la première valeur de tension et la deuxième valeur de tension et la différence entre la première valeur de courant et la deuxième valeur de courant, et l'appareil de détection de court-circuit est configuré de façon à : en réponse au fait que le rapport entre la différence entre la première valeur de tension et la deuxième valeur de tension et la différence entre la première valeur de courant et la deuxième valeur de courant est moins que le seuil spécifié, déterminer que l'impédance de masse est moins que le seuil spécifié, et signaler ou envoyer les informations de défaut d'anomalie de l'impédance de masse.

**3.** Système d'alimentation selon la revendication 1 ou 2, le système d'alimentation comportant un transformateur, une extrémité de sortie du convertisseur étant connectée à un enroulement primaire du transformateur, un enroulement secondaire du transformateur étant configuré de façon à connecter à la charge en courant alternatif, et l'appareil de détection de court-circuit étant connecté à un point neutre équivalent sur le transformateur.

**4.** Système d'alimentation selon l'une quelconque des revendications 1 à 3, dans lequel l'appareil de détection de court-circuit est configuré de façon à fournir la première valeur de tension au point neutre équivalent à un premier moment, et à fournir la deuxième valeur de tension au point neutre équivalent à un deuxième moment, un intervalle de temps entre le premier moment et le deuxième moment étant un multiple entier d'un cycle d'une tension en courant alternatif de sortie du convertisseur.

**5.** Système d'alimentation selon l'une quelconque des revendications 1 à 3, dans lequel l'appareil de détection de court-circuit est configuré de façon à : fournir une tension en courant alternatif au point neutre équivalent, la durée à haut niveau de la tension en courant alternatif étant un premier intervalle de temps, et la durée à bas niveau de la tension en courant alternatif étant un deuxième intervalle de temps ; obtenir la première valeur de tension fournie par l'appareil de détection de court-circuit pendant une période pendant laquelle la tension en courant alternatif est à un haut niveau et une première valeur moyenne de courant de l'appareil de détection de court-circuit dans le cas où la première valeur de tension est fournie ; et de façon à obtenir la deuxième valeur de tension fournie par l'appareil de détection de court-circuit pendant une période pendant laquelle la tension en courant alternatif est à un bas niveau et une deuxième valeur moyenne de courant de l'appareil de détection de court-circuit dans le cas où la deuxième valeur de tension est fournie, le premier intervalle de temps et le deuxième intervalle de temps étant des multiples entiers d'un cycle d'une tension en courant alternatif de sortie du convertisseur ; et

obtenir l'impédance de masse en se basant sur un rapport entre la différence entre la première valeur de tension et la deuxième valeur de tension et une différence entre la première valeur moyenne de courant et la deuxième valeur moyenne de courant.

6. Système d'alimentation selon la revendication 5, dans lequel une forme d'onde de la tension en courant alternatif fournie par l'appareil de détection de court-circuit est une onde carrée ou une onde trapézoïdale.

7. Système d'alimentation selon la revendication 6, dans lequel la forme d'onde de la tension en courant alternatif fournie par l'appareil de détection de court-circuit est une superposition de l'onde carrée et d'un signal fluctuant périodiquement, ou une superposition de l'onde trapézoïdale et du signal fluctuant périodiquement, un multiple entier d'un cycle du signal fluctuant périodiquement étant égal au premier intervalle de temps et au deuxième intervalle de temps.

8. Système d'alimentation selon l'une quelconque des revendications 1 à 7, dans lequel le convertisseur comporte un circuit onduleur, et le circuit onduleur comporte au moins un bras de pont et le condensateur de bus positif et le condensateur de bus négatif qui sont connectés en série, le bras de pont étant connecté en parallèle à deux extrémités du condensateur de bus positif et du condensateur de bus négatif qui sont connectés en série, une extrémité du bras de pont étant connectée à une extrémité de connexion du condensateur de bus positif et du condensateur de bus négatif, et l'autre extrémité du bras de pont étant configurée de façon à être couplée à la charge en courant alternatif.

9. Système d'alimentation selon la revendication 8, dans lequel le convertisseur comporte un circuit de conversion en courant continu, une extrémité d'entrée du circuit de conversion en courant continu est configurée de façon à connecter à l'alimentation en courant continu, et une extrémité de sortie d'électrode positive et une extrémité de sortie d'électrode négative du circuit de conversion en courant continu sont connectées respectivement aux deux extrémités du condensateur de bus positif et du condensateur de bus négatif qui sont connectés en série.

10. Procédé pour détecter une impédance de masse, le procédé comprenant :

la fourniture d'une première valeur de tension à un point neutre équivalent, l'obtention d'une première valeur de courant qui est fournie dans le cas où la première valeur de tension est fournie, la fourniture d'une deuxième valeur de tension au point neutre équivalent, et l'obtention d'une deuxième valeur de courant qui est fournie dans le cas où la deuxième valeur de tension est fournie ; et

en réponse au fait qu'un rapport entre une différence entre la première valeur de tension et la deuxième valeur de tension et une différence entre la première valeur de courant et la deuxième valeur de courant est moins qu'un seuil spécifié, le signalement ou l'envoi d'informations de défaut d'anomalie de l'impédance de masse,

une différence de potentiel de masse du point neutre équivalent étant positivement corrélée avec une différence de potentiel de masse d'un point neutre, le point neutre étant un point de connexion en série entre un condensateur de bus positif et un condensateur de bus négatif dans un convertisseur, une extrémité d'entrée du convertisseur étant configurée de façon à connecter à une alimentation en courant continu, et une extrémité de sortie du convertisseur étant configurée de façon à être couplée à une charge en courant alternatif.

11. Procédé selon la revendication 10, dans lequel l'impédance de masse est positivement corrélée avec le rapport entre la différence entre la première valeur de tension et la deuxième valeur de tension et la différence entre la première valeur de courant et la deuxième valeur de courant, et le procédé comprenant :

en réponse au fait que le rapport entre la différence entre la première valeur de tension et la deuxième valeur de tension et la différence entre la première valeur de courant et la deuxième valeur de courant est moins que le seuil spécifié, la détermination que l'impédance de masse est moins que le seuil spécifié, et le signalement ou l'envoi des informations de défaut d'anomalie de l'impédance de masse.

12. Procédé selon la revendication 11, le procédé comprenant :

la fourniture de la première valeur de tension au point neutre équivalent à un premier moment, et la fourniture de la deuxième valeur de tension au point neutre équivalent à un deuxième moment, un intervalle de temps entre le premier moment et le deuxième moment étant un multiple entier d'un cycle d'une tension en courant alternatif de sortie du convertisseur.

13. Procédé selon la revendication 11, le procédé comprenant :

la fourniture d'une tension en courant alternatif au point neutre équivalent, la durée à haut niveau de la tension en courant alternatif étant un premier intervalle de temps, et la durée à bas niveau de la tension en courant alternatif étant un deuxième intervalle de temps ; l'obtention de la première valeur de tension fournie au point neutre équivalent pendant une période pendant laquelle la tension en courant alternatif est à un haut niveau et d'une première valeur moyenne de courant dans le cas où la première valeur de tension est fournie ; et l'obtention de la deuxième valeur de tension fournie au point neutre équivalent pendant une période pendant laquelle la tension en courant alternatif est à un bas niveau et d'une deuxième valeur moyenne de courant fournie dans le cas où la deuxième valeur de tension est fournie, le premier intervalle de temps et le deuxième intervalle de temps étant des multiples entiers d'un cycle d'une tension en courant alternatif de sortie du convertisseur ; et

l'obtention de l'impédance de masse en se basant sur un rapport entre la différence entre la première valeur de tension et la deuxième valeur de tension et une différence entre la première valeur moyenne de courant et la deuxième valeur moyenne de courant.

14. Procédé selon la revendication 13, dans lequel :

la forme d'onde de la tension en courant alternatif fournie au point neutre équivalent est une onde carrée ou une onde trapézoïdale ; ou
la forme d'onde de la tension en courant alternatif fournie au point neutre équivalent est une superposition de l'onde carrée et d'un signal fluctuant périodiquement, ou une superposition de l'onde trapézoïdale et du signal fluctuant périodiquement, un multiple entier d'un cycle du signal fluctuant périodiquement étant égal au premier intervalle de temps et au deuxième intervalle de temps.

15. Procédé selon la revendication 10 ou 11, dans lequel :
l'extrémité de sortie du convertisseur est configurée de façon à connecter à un enroulement primaire d'un transformateur, et un appareil de détection de court-circuit est connecté à un point neutre équivalent sur le transformateur

FIG. 1

FIG. 2

FIG. 3

FIG. 4

FIG. 5

FIG. 6

FIG. 7

FIG. 8

Equivalent circuit 1        Equivalent circuit 2

FIG. 9

FIG. 10

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013322133 A1